# EUROPEAN PATENT APPLICATION

(11) **EP 2 031 085 A1**
(43) Date of publication of application: **04.03.2009**
(21) Application number: 06767147.9
(22) Date of filing: 22.06.2006
(51) Int. Cl.: C23C 14/24

(54) **ARC EVAPORATION SOURCE AND VACUUM EVAPORATION SYSTEM**

(71) Applicant: Shinmaywa Industries, Ltd., Takarazuka-shi, Hyogo 665-8550 (JP)
(72) Inventor: KOIZUMI, Yasuhiro c/o Research and Development Centre, Hyogo 665-8550 (JP); NOSE, Kouichi c/o Research and Development Centre, Hyogo 665-8550 (JP)
(74) Representative: Piésold, Alexander James
(86) International application number: PCT/JP2006/312489
(87) International publication number: WO 2007/148396

(57) **Abstract**

An arc evaporation source and a vacuum deposition system capable of properly collecting an evaporated material emitted from a cathode in vacuum arc discharge are provided. An arc evaporation source (100) includes a first electrode and a second electrode (14A, 14B) disposed so as to face each other with a gap (G) therebetween. The first and second electrodes (14A, 14B) are configured such that at least one of the first and second electrodes (14A, 14B) is operable as a cathode, and the other one of the first and second electrodes (14A, 14B) is operable to collect an evaporated material emitted from the cathode, based on a vacuum arc discharge occurring between the cathode and an anode.

## Description

### Technical Field

The present invention relates to an arc evaporation source and a vacuum deposition system. More particularly, the present invention relates to an arc evaporation source and a vacuum deposition system for improving the capability of collecting an evaporated material in a vacuum arc deposition method.

### Background Art

Generally, when a vacuum arc discharge occurs, a high temperature and low-active cathode spot is created on a cathode (target), and from this cathode spot, an electrode material (e.g., cathode material ions) having high energy is emitted into a vacuum. A method that utilizes such electrode material to form a film on the surface of a workpiece is called a vacuum arc deposition method. The vacuum arc deposition method has various advantages such as excellent adhesion of the film to the workpiece that is achieved by obtaining a high-energy electrode material directly from solid metal, and omission of vessels such as a crucible or a boat for storing the electrode material.
However, a great drawback of the vacuum arc deposition method is that, during the vacuum arc discharge, particles (20 to 100 µm in particle diameter) called droplets are produced from the cathode spot of the cathode, and adhere to the workpiece surface, degrading uniformity of the film on the workpiece surface.

Under the circumstance, various kinds of anti-droplets techniques have been conventionally proposed, for example, suppressing the generation of the droplets (e.g., pulse discharging method), using a vacuum space from which the droplets have been removed (e.g., shielding method); and using a vacuum space containing therein few droplets.
In one example of the anti-droplet techniques, an electric discharge power is applied, in a vacuum atmosphere, across a first electrode and a second electrode that are arranged in close proximity and so as to face each other. Thereby, surfaces of the first and second electrodes are mutually heated, and thermal electron emission from the first and second electrodes is activated, enabling surfaces of the two electrodes to be heated even more. So, a cathode spot created on the first electrode or second electrode serving as a cathode becomes larger, producing the effect of significantly reducing the generation of droplets on the first or second electrode (See Patent document 1).
Patent document 1: Japanese Laid-Open Patent Application Publication No. 2002-69664

### Disclosure of the Invention

### Problems to be Solved by the Invention

Under the circumstances, from a view point apart from the concept of the existing anti-droplet techniques, the inventors of the present invention have been making efforts to develop a technique for positively collecting and reusing the droplets generated at a cathode in vacuum arc discharge and the electrode material such as a cathode ion film material that is reusable for vapor-deposition on a workpiece surface (hereinafter collectively referred to as 'evaporated material').
It appears that in the plasma processing technique disclosed in the Patent document 1, in which the first and second electrodes are disposed so as to face each other, the droplets emitted from the first and second electrodes migrate through a gap therebetween and adhere to each other, and those droplets are collected.

However, in the plasma processing technique disclosed in Patent document 1, attention is focused on only suppressing the generation of droplets, and hence collecting and reusing the evaporated material are not taken into account. In other words, the plasma processing technique is completely different from the objective associated with the present invention that the evaporated material is adjusted to a state where the material is emitted most easily, and collected and reused.
In the plasma processing technique disclosed in Patent document 1, when either the first or second electrode is a cathode, the remaining electrode is an anode.
So, even though the droplets can be collected at the anode, it is difficult to collect cathode ions (positive ions) emitted from the cathode. For this reason, the technique disclosed in Patent document 1 leaves much to be improved when compared with the objective associated with the present invention, in which the evaporated material is collected and reused.
The present invention has been made under the circumstances, and an object of the present invention is to provide an arc evaporation source and a vacuum deposition system which are capable of properly collecting the evaporated material emitted from the cathode in the vacuum arc discharge.

### Means for Solving the Problems

In order to solve the aforementioned problem, an arc evaporation source of the present invention comprises a first electrode and a second electrode which are disposed so as to face each other with a gap therebetween, wherein the first and second electrodes are configured such that at least one of the first and second electrodes is operable as a cathode, and the other one of the first and second electrodes is operable to collect an evaporated material emitted from the cathode, based on a vacuum arc discharge occurring between the cathode and an anode.
A vacuum deposition system of the present invention comprises a vacuum chamber in which the above described arc evaporation source is disposed in an interior thereof whose pressure is capable of being reduced; and an electric power supply means for supplying to the cathode and to the anode an electric power for causing the vacuum arc discharge to occur between the cathode and the anode.
According to the arc evaporation source and the vacuum deposition system configured as described above, the evaporated material emitted from the cathode is suitably adhered to and collected at the other electrode in the vacuum arc discharge.
When the anode is the vacuum chamber, a circuit configuration of the vacuum arc discharge can be simplified.

The evaporated material is droplets and ions comprising a material forming the cathode.
The vacuum deposition system may further comprise a workpiece disposed in the interior of the vacuum chamber, and the first and second electrodes may be rod members, and may be aligned in a longitudinal direction of the first and second electrodes to form the gap between end surfaces of the first and second electrodes; and the workpiece may be disposed so as to face the gap.
The vacuum deposition system may further comprise a collecting member disposed in the interior of the vacuum chamber, for collecting the evaporated material, and a surface of the collecting member may be curved to surround the gap, except for a region between the workpiece and the gap.

With such placement of the collecting member, most of the electrode material emitted from the first and second electrodes is adhered to an inner surface of the collecting member in directions in which the gap is within range of vision, except for the region in which the work piece is disposed.
The vacuum deposition system may have a first operating state in which the first electrode is the cathode; and a second operating state in which the second electrode is the cathode. The vacuum deposition system may further comprise a switching means for switching between the first operating state and the second operating state.
In such a configuration, it is preferable that, by repeatedly switching between the first operating state and the second operating state for each specific period by the switching means in the vacuum deposition system, the evaporated material collected at the second electrode in a first operating state is reused as a part of the second electrode serving as the cathode in a second operating state subsequent to that first operating state, while the evaporated material collected at the first electrode in a second operating state is reused as a part of the first electrode serving as the cathode in a first operating state subsequent to that second operating state.
The electric power supply means may be a DC power supply; and the switching means may be a switch for switching such that a cathode terminal of the DC power supply is connected to the first electrode or to the second electrode.
The electric power supply means may be an AC power supply, and the switching means may have rectifying devices between one terminal of the AC power supply and the first electrode and between the other terminal of the AC power supply and the second electrode, for rectifying the electrical power supplied from the AC power supply.

According to the vacuum deposition system including the above AC power supply, by correctly controlling the AC frequency of the AC power supply, the uneven thickness distribution of the film material deposited on the workpiece in the first operating state and the uneven thickness distribution of the film material deposited on the workpiece in the second operating state are mutually cancelled, thus preventing occurrence of the uneven thickness distribution of the film material deposited on the workpiece.

The electric power supply means may include a first DC power supply having a negative terminal connected to the first electrode and a positive terminal connected to the anode; and a second DC power supply having a negative terminal connected to the second electrode and a positive terminal connected to the anode.
According to the vacuum deposition system including the first and second DC power supplies, the electric power supply from the first DC power supply to the first electrode to enable the vacuum arc discharge to occur and the electric power supply from the second DC power supply to the second electrode to enable the vacuum arc discharge to occur are carried out at the same time. Thereby, the uneven thickness distribution of the film material deposited on the workpiece in the first operating state and the uneven thickness distribution of the film material deposited on the workpiece in the second operating state are mutually cancelled, thus preventing occurrence of the uneven thickness distribution of the film material deposited on the workpiece.

These and other objectives of the present invention as well as features and advantages thereof will be fully understood from the following detailed description of a preferred embodiment in conjunction with the accompanying drawings.

### Effects of the Invention

According to the present invention, an arc evaporation source and a vacuum deposition system which are capable of properly collecting an evaporated material emitted from a cathode in a vacuum arc discharge are attained.

### Brief Description of the Drawings

[Fig. 1] Fig. 1 is a cross-sectional view showing a configuration of an arc evaporation source for a vacuum deposition system according to an embodiment of the present invention;
[Fig. 2] Fig. 2 is a cross-sectional view showing a configuration of the arc evaporation source for the vacuum deposition system according to the embodiment of the present invention;
[Fig. 3] Fig. 3 is a schematic view illustrating one example of a configuration of the vacuum deposition system according the embodiment;
[Fig. 4] Fig. 4 is a view showing a scattering pattern of a film material to a workpiece in a first operating state, and a scattering pattern of the film material in a second operating state;
[Fig. 5] Fig. 5 is a schematic view illustrating one example of a configuration of a vacuum deposition system according to an alternative example 1;
[Fig. 6] Fig. 6 is a schematic view illustrating one example of a configuration of a vacuum deposition system according to an alternative example 2; and
[Fig. 7] Fig. 7 is a schematic view illustrating one example of a configuration of a vacuum deposition system according to an alternative example 3.

### Explanation of Reference Numerals

- 10A, 10B: arc evaporation unit
- 11A, 11B: cover member
- 12A, 12B: bracket
- 13A, 13B: electrode retaining member
- 14A: first electrode
- 14B: second electrode
- 15: flange
- 16A, 16B: electric power feeding rod member
- 17A, 17B: insulating member
- 20: vacuum chamber
- 21: workpiece
- 22: twitch
- 23: DC power supply
- 31A: first diode
- 31B: second diode
- 31C: third diode
- 31D: fourth diode
- 32: AC power supply
- 41: first DC power supply
- 42: second DC power supply
- 51: collecting member
- 52: inner surface
- 100: arc evaporation source
- 110, 120, 130, 140: vacuum deposition system
- PA, PB: center axis
- G: gap
- SA1, SA2, SB1, SB2: circular surface

### Best Mode for Carrying Out the Invention

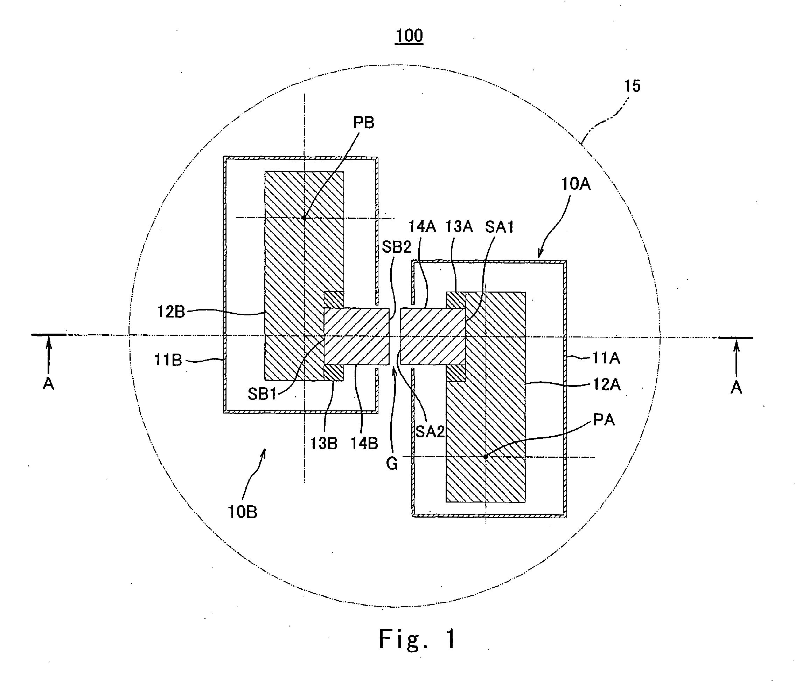

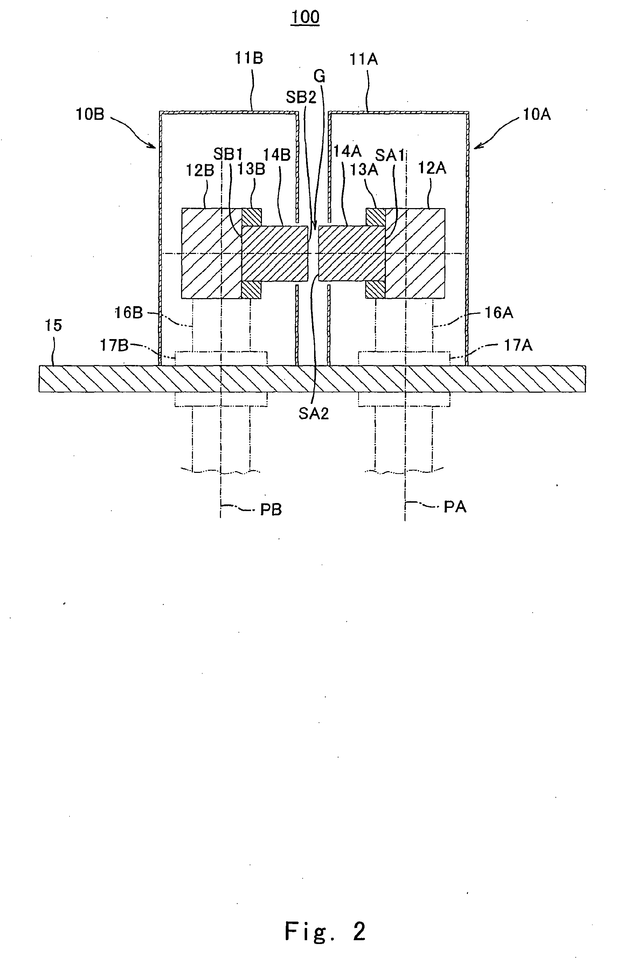

Hereinafter, preferred embodiment of the present invention will be described, by referring to the accompanying drawings. Figs. 1 and 2 are cross-sectional views showing configurations of an arc evaporation source for a vacuum deposition system according to the embodiment of the present invention. Fig. 1 is a view showing a cross-sectional view taken along a plane parallel to a flange 15 in the center parts of first and second electrodes 14A and 14B of arc evaporation units 10A and 10B. Fig. 2 is a cross-sectional view taken along the line A-A in Fig. 1.

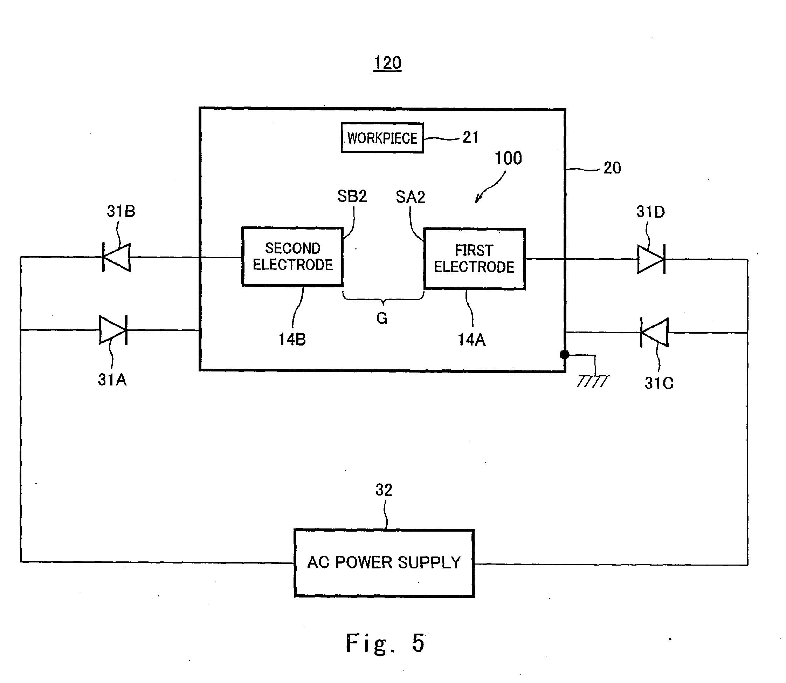

As shown in Figs. 1 and 2, an arc evaporation source 100 includes the pair of arc evaporation units 10A and 10B, and a disc-shaped metal flange 15 for retaining electric power feeding rod members 16A and 16B of the arc evaporation units 10A, 10B via insulating members 17A and 17B of the arc evaporation units 10A and 10B.
As shown in Fig. 1, the arc evaporation unit 10A includes a first electrode 14A that is made of noble metal and is of a columnar shape (rod shape), a metal electrode retaining member 13A of a square plate shape that has a round hole at a center thereof for retaining the electrode 14A inserted thereinto, and a substantially-rectangular metal bracket 12A for fastening and retaining the electrode retaining member 13A using an appropriate fastening means (screw, etc. not shown), with a circular surface SA1 of one end of the first electrode 14A in contact with the metal bracket 12A.
As shown in Fig. 2, the arc evaporation unit 10A further includes a columnar electric power feeding rod member 16A that is made of metal, extends through a through-hole (not shown) formed in the flange 15 and is fastened by an appropriate fastening means (screw, etc. not shown) to a side surface of the bracket 12A (a surface perpendicular to a contact surface of the first electrode 14A), so as to be capable of feeding a predetermined electric power to the first electrode 14A via the bracket 12A, a cylindrical insulating member 17A that is inserted between the electric power feeding rod member 16A and a circumferential surface of the through-hole of the flange 15 so as to be capable of maintaining the flange 15 electrically isolated from the electric power feeding rod member 16A, and a metal (stainless) cover member 11A that has a through-hole through which the first electrode 14A protrude for a predetermined length from the circular surface SA2 of the other end of the first electrode 14A and is attached to the flange 15 by an appropriate means (screw, etc. not shown) so as to cover the bracket 12A, the electrode retaining member 13A, the first electrode 14A, a part of the electric power feeding rod member 16A on the first electrode 14A side with respect to the flange 15, and a part of the insulating member 17A on the first electrode 14A side with respect to the flange 15.
The configuration of the arc evaporation unit 10B is the same as that of the arc evaporation unit 10A, and the components included in the arc evaporation unit 10B corresponding to those of the arc evaporation unit 10A are identified by reference symbols B instead of A in last part of reference numerals assigned to the components of the arc evaporation unit 10A. Therefore, a detailed description of each component of the arc evaporation unit 10B is omitted herein.
The columnar first and second electrodes 14A and 14B axially extend through the through-holes of the cover members 11A and 11B close to each other and thus are placed to so as to face each other with a specified disc-shaped gap G formed between the circular surfaces SA2 and SB2 of the other ends of the first and second electrodes 14A and 14B. As described in detail later, the first and second electrodes 14A and 14B serve as a cathode for the vacuum arc discharge and a member for collecting the evaporated material emitted from the cathode in the vacuum arc discharge.
As in Figs. 1 and 2, the bracket 12A retaining the first electrode 14A by the electrode retaining member 13A is rotatable within a predetermined rotation range around a center axis PA of the electric power feeding rod member 16A by rotating the electric power feeding the rod member 16A in a circumferential direction thereof. Likewise, the bracket 12B retaining the second electrode 14B by the electrode retaining member 13B is rotatable within a predetermined rotation range around a center axis PB of the electric power feeding rod member 16B by rotating the electric power feeding rod member 16B in the circumferential direction thereof. The rotation of the brackets 12A, 12B allows the dimension of the gap G between the circular surface SA2 of the other end of the first electrode 14A and the circular surface SB2 of the other end of the second electrode 14B to be easily adjusted and to bring the two electrodes 14A and 14B into contact with each other and to part them away from each other so that arc firing (described later) for the vacuum arc discharge occurs.
Specifically, the electrode retaining members 13A and 13B have protrusions (not shown) protruding from side surfaces of the retaining members 13A and 13B and are provided with slits (not shown) formed by cutting out widthwise center regions of these protrusions along a radial direction of round holes so as to reach the round holes. By fastening means (screw, etc. now shown) for fastening the protrusions in the circumferential direction of the round holes, the first and second electrodes 14A and 14B are fastened to the electrode retaining members 13A and 13B, respectively. Note that the electrode retaining members 13A and 13B are made of metal (e.g., stainless) that is resistant to the heat generated by the vacuum arc discharge and transferred via the first and second electrodes 14A and 14B.
The brackets 12A and 12B, and the electric power feeding rod members 16A and 16B have internal hollow regions (not shown), and a coolant such as water supplied from a coolant supply means (not shown) is circulated in the hollow regions. By heat exchange with the coolant via the brackets 12A and 12B, an event that the first and second electrodes 14A and 14B are elevated in temperatures, which would be caused by the vacuum arc discharge, is properly suppressed.
The cover members 11A and 11B are electrically grounded via the flange 15 and a vacuum chamber 20 (described later). In this configuration, when an electric power for vacuum arc discharge is applied to the electric power feeding rod members 16A and 16B, the brackets 12A and 12B, the electrode retaining members 13A and 13B, and the first and second electrodes 14A and 14B, the cover members 11A and 11B serve as shield plates capable of limiting discharge areas to be the circular surfaces SA2 and SB2 of the other ends of the first and second electrodes 14A and 14B, in order to inhibit occurrence of abnormal electric discharge.
Subsequently, a description will be given of an example of a vacuum deposition system in which the above described arc evaporation source 100 is mounted inside the vacuum chamber 20.

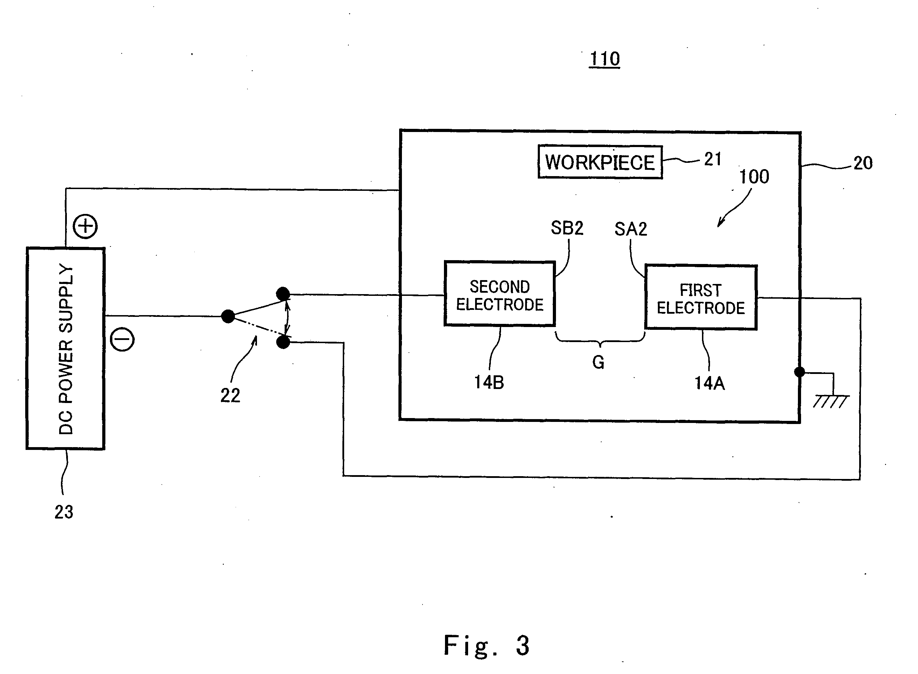

Fig. 3 is a schematic view illustrating one example of a configuration of a vacuum deposition system according the embodiment.
In order to simplify the figure, only the first and second electrodes 14A and 14B are illustrated as representing the components of the arc evaporation source 100. Actually, however, the first and second electrodes 14A and 14B of the arc evaporation units 10A and 10B of the arc evaporation source 100 shown in Figs. 1 and 2 are inserted into the vacuum chamber 20 through an opening (not shown) provided on a wall portion thereof in the vacuum deposition system 110, and then the flange 15 of the arc evaporation source 100 is subjected to vacuum-sealing using a sealing member (O-ring, etc. not shown) and fastened to the wall portion of the vacuum chamber 20 by an appropriate fastening means (screw, etc. not shown). The same occurs in the configuration of Figs. 5, 6 and 7.
With reference to Fig. 3, the vacuum deposition system 110 includes the vacuum chamber 20 capable of reducing an internal pressure thereof, the arc evaporation source 100 having the first and second electrodes 14A and 14B disposed at appropriate locations inside the vacuum chamber 20, a workpiece 21 disposed at an appropriate location inside the vacuum chamber 20, a DC power supply (electric power supply means) 23 having a positive terminal connected to the vacuum chamber 20 and a negative terminal connected to either one of the first and second electrodes 14A and 14B via a switch 22 so that vacuum arc discharge occurs between one of the first and second electrodes 14A and 14B and the vacuum chamber 20 (positive electrode, anode). The vacuum chamber 20 is electrically grounded, and thereby, the positive terminal of the DC power supply 23 is maintained at a ground potential.
In this example, a structural member of the vacuum chamber 20 is made of an electrically-conductive material and forms a part of a circuit (member) for carrying out the vacuum arc discharge, while the first and second electrodes 14A and 14B are electrically isolated from the vacuum chamber 20. As a matter of course, an anode (metal plate, etc. not shown) independent of the vacuum chamber 20 may be disposed within the vacuum chamber 20 and the positive terminal of the DC power supply 23 may be connected to the anode.
Specifically, the first and second electrodes 14A and 14B are aligned in a longitudinal direction thereof to form the gap G between the circular surfaces SA2 and SB2 (end surfaces) of these electrodes, while the workpiece 21 is placed to be spaced apart laterally and radially from the first and second electrodes 14A and 14B such that the workpiece 21 faces the gap G It has been found that, by placing the workpiece 21 in such a direction with respect to the electrodes 14A and 14B, the droplets generated by the vacuum arc discharge between one of the first and second electrodes 14A and 14B and the vacuum chamber 20 scatters in small amount toward the workpiece 21. As a matter of course, if the adhesion of the droplets to the workpiece 21 is confirmed, then the various existing anti-droplets techniques may also be employed within the vacuum chamber 20 to inhibit the adhesion of the droplets onto the workpiece 21.
The DC power supply 23 outputs a voltage of approximately 10 to 100 V (volt) and a current of approximately 10 to 500 A (ampere) in the form of a DC power.
In the configuration of the vacuum deposition system 110 as described above, when the negative terminal of the DC power supply 23 is connected to the first electrode 14A made of noble metal (gold, silver, etc.) and the second electrode 14B is placed in an electrically-floating state by switching of the switch 22, one operating state (hereinafter referred to as 'first operating state') of the vacuum deposition system 110 is realized, in which the first electrode 14A serves as a cathode (target) in the vacuum arc discharge. In this operating state, based on the vacuum arc discharge occurring between the first electrode 14A and the vacuum chamber 20, the electrode material of the noble metal forming the first electrode 14A is uniformly emitted from the circular surface SA2 of the other end of the first electrode 14A toward directions in which the circular surface SA2 is within range of vision. As a result, a part of the electrode material arrives on the surface of the workpiece 21 and is deposited thereon as a film material. At the same time, from the circular surface SA2 of the other end of the first electrode 14A, the droplets of the noble metal forming the first electrode 14A are emitted mainly in the axial direction of the first electrode 14A. So, a part of the electrode material emitted from the first electrode 14A and the droplets (evaporated material) are adhered to the circular surface SB2 of the other end of the second electrode 14B that faces the circular surface SA2 of the other end of the first electrode 14A with the gap G therebetween. Thereby, the evaporated material can be efficiently collected at the second electrode 14B.
On the other hand, when the negative terminal of the DC power supply 23 is connected to the second electrode 14B made of noble metal (gold, silver, etc.) and the first electrode 14A is placed in an electrically-floating state by switching of the switch 22, another operating state (hereinafter referred to as 'second operating state') of the vacuum deposition system 110 is realized, in which the second electrode 14B serves as a cathode (target) in the vacuum arc discharge. In this operating state, based on the vacuum arc discharge occurring between the second electrode 14B and the vacuum chamber 20, the electrode material of the noble metal forming the second electrode 14B is uniformly emitted from the circular surface SB2 of the other end of the second electrode 14B in directions in which the circular surface SB2 is within range of vision. As a result, a part of the electrode material arrives on the surface of the workpiece 21 and is deposited thereon as a film material. At the same time, from the circular surface SB2 of the other end of the second electrode 14B, the droplets of the noble metal forming the second electrode 14B are emitted mainly in the axial direction of the second electrode 14B. So, the evaporated material emitted from the second electrode 14B is adhered to the circular surface SA2 of the other end of the first electrode 14A that faces the circular surface SB2 of the other end of the second electrode 14B with the gap G therebetween. Thereby, the evaporated material can be efficiently collected at the first electrode 14A.
The vacuum deposition system 110 is favorable in that when the switch 22 switches between the first operating state and the second operating state at specific time intervals (e.g., in each batch cycle), the evaporated material collected at the second electrode 14B in the first operating state is reused as a part of the second electrode 14B serving as the cathode in a second operating state subsequent to that first operating state, and the evaporated material collected at the first electrode 14A in the second operating state is reused as a part of the first electrode 14A serving as the cathode in the first operating state subsequent to that second operating state.
The vacuum deposition system 110 includes a controller (not shown) for controlling an operation thereof. The vacuum arc discharge in the vacuum deposition system 110 is controlled correctly by this controller.
Subsequently, the operation of the vacuum deposition system 110 of this embodiment will be described.
It should be noted that the electric power supply conditions and gas conditions 20 for enabling the vacuum arc discharge to occur within the vacuum chamber 20 are based on known techniques, and hence, detailed description of them is omitted here.
After the workpiece 21 and the arc evaporation source 100 are installed inside the vacuum chamber 20 of the vacuum deposition system 110, a vacuum evacuation system is operated to introduce an electric discharge gas from an appropriate position on the wall portion of the vacuum chamber 20 so that the chamber 20 is maintained at a predetermined vacuum degree (e.g., 1 Pa).
Under this condition, the firing for the vacuum arc discharge is carried out, for example, by using a contact firing method. To be specific, the first and second electrodes 14A and 14B are rotated to bring the center axes PA and PB closer to each other (see Fig. 1) so that the first and second electrodes 14A and 14B contact each other. In this state, the current is conducted between the electrodes 14A and 14B, and thereafter, the first and second electrodes 14A and 14B are parted from each other. At that moment, a spark discharge is generated to induce the vacuum arc discharge.

After that, in order to carry out the first operating state of the vacuum deposition system 110, a predetermined electrical power is applied to the first electrode 14A and to the vacuum chamber 20. Thereby, based on the vacuum arc discharge occurring between the first electrode 14A and the vacuum chamber 20, the film material of the noble metal forming the first electrode 14A is deposited on the workpiece 21, and the evaporated material emitted from the first electrode 14A is collected at the second electrode 14B. The collected evaporated material is then reused in the subsequent second operating state.
Upon completion of one batch cycle, the vacuum deposition system 110 is released to atmosphere, the workpiece 21 inside the vacuum chamber 20 is replaced with another, and then, the vacuum arc discharge inducing operation is carried out in the same manner as described above. After that, in order to carry out the second operating state of the vacuum deposition system 110, a predetermined electric power is applied to the second electrode 14B and to the vacuum chamber 20. Thereby, based on the vacuum arc discharge between the second electrode 14B and the vacuum chamber 20, the film material of the noble metal forming the second electrode 14B is deposited on the workpiece 21, and the evaporated material emitted from the second electrode 14B is collected at the first electrode 14A. The collected evaporated material is then reused in the subsequent first operating state.

### [Alternative example 1]

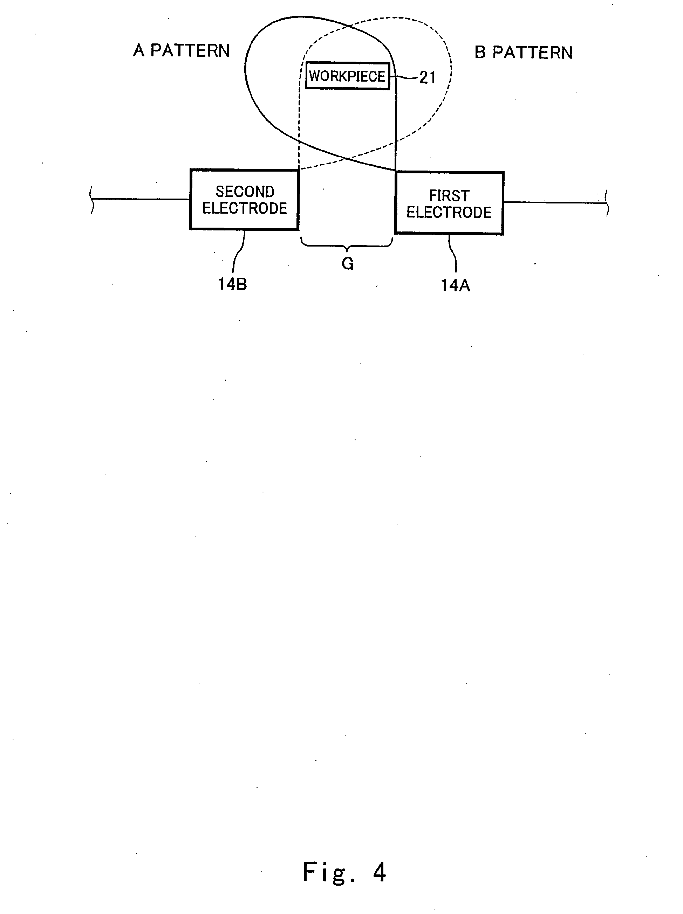

In the above-described embodiment, one example has been described, in which the first and second operating states of the vacuum deposition system 110 are switched in each batch cycle. However, when the switching occurs in each batch cycle in this way, the film material is deposited on the workpiece 21 in the first operating state based on scattering state of the film material according to A pattern as indicated by solid line as shown in Fig. 4, whereas the film material is deposited on the workpiece 21 in the second operating state based on scattering state of the film material according to B pattern as indicated by dotted line as shown in Fig. 4. So, the distribution of the scattering film material changes each time the state is switched (i.e., for each batch), which may eventually bring about uneven thickness distribution of the film material deposited on the workpiece 21.
Hereinafter, one example of a configuration of a vacuum deposition system capable of properly preventing the uneven thickness distribution of the film material deposited on the workpiece 21 will be described.
Fig. 5 is a schematic view showing one example of a configuration of a vacuum deposition system according to this alternative example.
With reference to Fig. 5, instead of the DC power supply 23 and the switch 22 in the vacuum deposition system 110 (Fig. 3) of the embodiment, a vacuum deposition system 120 of the alternative example includes an AC power supply 32 (electric power supply means), and four first through fourth diodes (rectifying devices) 31A, 31B, 31C, and 31D.
Since the configuration of the vacuum deposition system 120 is identical to the configuration of the vacuum deposition system 110 (Fig. 3) except for the above, the configuration common to these systems will not be further described.

The AC power supply 32 outputs a voltage of approximately 10 to 100 V (volt) and a current of approximately 10 to 500 A (ampere) in the form of an AC power such as a rectangular wave.
The first diode 31A is placed on a wiring between one terminal of the AC power supply 32 and the vacuum chamber 20 such that the first diode 31A is oriented so as to be electrically conductive in the direction from the one terminal toward the chamber 20 (forward orientation). The second diode 31B is placed on a wiring between the one terminal of the AC power supply 32 and the second electrode 14B such that the second diode 31B is oriented so as not to be electrically conductive in the direction from the one terminal toward the second electrode 14B (reverse orientation).

The third diode 31C is placed on a wiring between the other terminal of the AC power supply 32 and the vacuum chamber 20 such that the third diode 31C is oriented so as to be electrically conductive in the direction from the other terminal toward the chamber 20 (forward orientation). The fourth diode 31D is placed on a wiring between the other terminal of the AC power supply 32 and the first electrode 14A such that the fourth diode 31D is oriented so as not to be electrically conductive in the direction from the other terminal toward the first electrode 14A (reverse orientation).
In the above configuration of the vacuum deposition system 120 as described above, minus potential is applied to the first and second electrodes 14A and 14B alternately according to an alternating current cycle of the AC power supply 32, on the basis of a potential of the vacuum chamber 20 (actually, ground potential).
By doing so, the first operating state (film material scattering state of A pattern in Fig. 4) and the second operating state (film material scattering state of B pattern in Fig. 4) of the vacuum deposition system 120 are automatically switched many times at a single interval during one batch cycle so as to correspond to AC frequency of the AC power supply 32. Thus, by correctly controlling the AC frequency of the AC power supply 32, the uneven thickness distribution of the film material deposited on the workpiece 21 in the first operating state and the uneven thickness distribution of the film material deposited on the workpiece 21 in the second operating state are mutually cancelled, thus preventing occurrence of the uneven thickness distribution of the film material deposited on the workpiece 21.

### [Alternative example 2]

Hereinafter, another example of a configuration of a vacuum deposition system capable of properly preventing occurrence of the uneven thickness distribution of the film material deposited on the workpiece 21 shown in the Fig. 4 will be described.

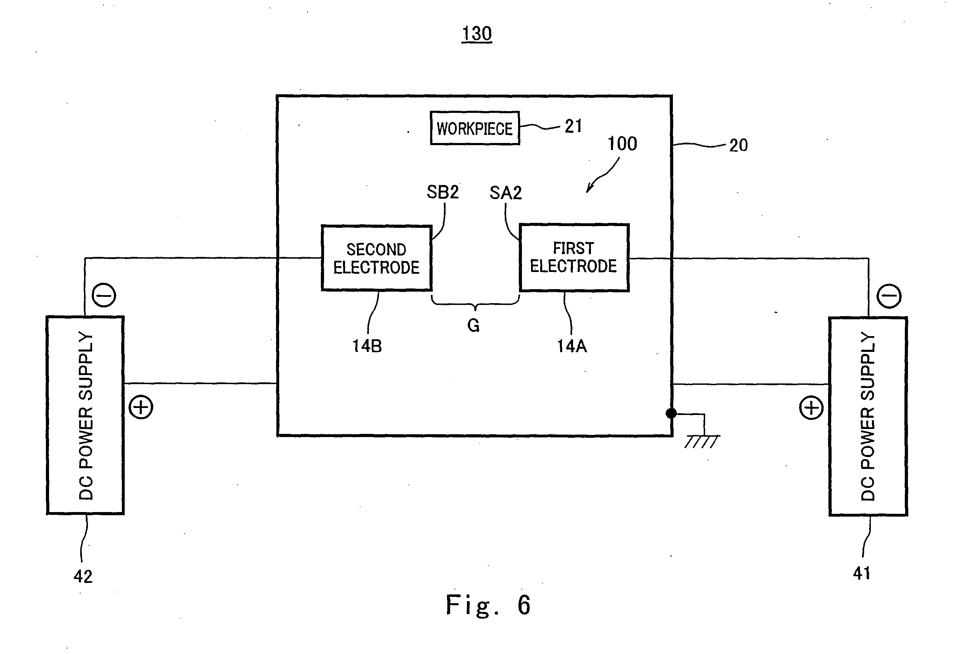

Fig. 6 is a schematic view showing one example of a configuration of the vacuum deposition system according to this alternative example.
With reference to Fig. 6, instead of the DC power supply 23 and the switch 22 in the vacuum deposition system 110 (Fig. 3) of this embodiment, a vacuum deposition system 130 of the alternative example includes a first DC power supply 41 (electric power supply means) capable of supplying an electric power to the first electrode 14A, and a second DC power supply 42 (electric power supply means) capable of supplying an electric power to the second electrode 14B.
Since the configuration of the vacuum deposition system 120 is identical to that of the vacuum deposition system 110 (Fig. 3) except for the above, the configuration common to these systems will not be further described.
In the first DC power supply 41, a positive terminal thereof is connected to the vacuum chamber 20 and a negative terminal thereof is connected to the first electrode 14A so as to cause the vacuum arc discharge to occur between the first electrode 14A (cathode, target) and the vacuum chamber 20 (anode). The vacuum chamber 20 is electrically grounded, and thereby, the positive terminal of the first DC supply power 41 is maintained at the ground potential.

Likewise, in the second DC power supply 42, a positive terminal thereof is connected to the vacuum chamber 20 and a negative terminal thereof is connected to the second electrode 14B so as to cause the vacuum arc discharge to occur between the second electrode 14B (cathode, target) and the vacuum chamber 20 (anode). The vacuum chamber 20 is electrically grounded, and thereby, the positive terminal of the second DC power supply means 42 is maintained at the ground potential.
According to the configuration of the vacuum deposition system 130 as described above, the electric power supply from the first DC power supply 41 to the first electrode 14A to enable the vacuum arc discharge to occur and the electric power supply from the second DC power supply 42 to the second electrode 14B to enable the vacuum arc discharge to occur are carried out at the same time. Thereby, the uneven thickness distribution of the film material deposited on the workpiece 21 in the first operating state and the uneven thickness distribution of the film material deposited on the workpiece 21 in the second operating state are mutually cancelled, thus preventing occurrence of the uneven thickness distribution of the film material deposited on the workpiece 21.
A drawback of this alternative example may be that it is difficult to collect the cathode ions (positive ions) at the first and second electrodes 14A and 14B.

### [Alternative example 3]

In the first operating state of the vacuum deposition system 110, based on the vacuum arc discharge occurring between the first electrode 14A and the vacuum chamber 20, the electrode material of the noble metal forming the first electrode 14A is uniformly emitted from the circular surface SA2 of the other end of the electrode 14A in directions in which circular surface SA2 is within range of vision. Likewise, in the second operating state of the vacuum deposition system 120, based on the vacuum arc discharge occurring between the second electrode 14B and the vacuum chamber 20, the electrode material of the noble metal forming the second electrode 14B is uniformly emitted from the circular surface SB2 of the other end of the second electrode 14B in directions in which the surface SB2 is within range of vision. So, the electrode material emitted from the first and second electrodes 14A and 14B in directions in which the gap G (the circular surfaces SA2 and SB2) is within range of vision, excluding the region in which the workpiece 21 is disposed, is not collected but is adhered to the wall portion and internal structural elements of the vacuum chamber 20.
Hereinafter, one example of a configuration of a vacuum deposition system for collecting the electrode material will be described.

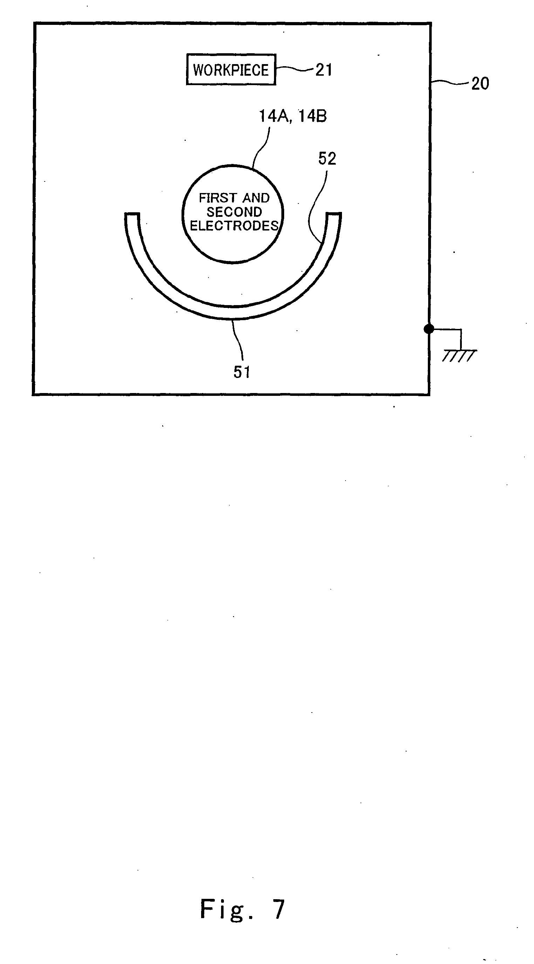

Fig. 7 is a schematic view showing one example of the configuration of the vacuum deposition system according to the alternative example, as viewed from the axial directions of the first and second electrodes 14A and 14B.

With reference to Fig. 7, a vacuum deposition system 140 includes a collecting member 51 that is obtained by splitting a cylindrical member substantially in two and is placed inside the vacuum chamber 20.
To be specific, the collecting member 51 is disposed with a longitudinal direction thereof (direction perpendicular to a width direction thereof) made in parallel with the axial direction of the first and second electrodes 14A and 14B, and an inner surface 52 of the collecting member 51 is curved so as to surround the gap G except for a region between the workpiece 21 and the gap G.
According to the collecting member 51 as described above, most of the electrode material emitted from the first and second electrodes 14A and 14B in directions in which the gap G (circular surfaces SA2 and SB2) is within range of vision, excluding the region in which the workpiece 21 is disposed, is adhered to the inner surface 52 of the collecting member 51. Then, the collecting member 51 with the electrode material adhered thereto is taken out of the vacuum chamber 20, and the electrode material is removed from the collecting member 51 by a suitable removing method and thus is surely collected.
Numerous modifications and alternative embodiments of the invention will be apparent to those skilled in the art in view of the foregoing description. Accordingly, the description is to be construed as illustrative only, and is provided for the purpose of teaching those killed in the art the best mode of carrying out the invention. The details of the structure and/or function maybe varied substantially without departing from the spirit of the invention and all modifications which come within the scope of the appended claims are reserved.

### Industrial Applicability

An arc evaporation source and a vacuum deposition system of the present invention are useful as an apparatus for forming a film on a workpiece, for example, by a vacuum arc discharge.

## Claims

1. An arc evaporation source comprising:
a first electrode and a second electrode which are disposed so as to face each other with a gap therebetween, wherein:
the first and second electrodes are configured such that at least one of the first and second electrodes is operable as a cathode, and the other one of the first and second electrodes is operable to collect an evaporated material emitted from the cathode, based on a vacuum arc discharge occurring between the cathode and an anode.

2. A vacuum deposition system comprising:
a vacuum chamber in which an arc evaporation source according to claim 1 is disposed in an interior thereof whose pressure is capable of being reduced ; and
an electric power supply means for supplying to the cathode and to the anode an electric power for causing the vacuum arc discharge to occur between the cathode and the anode.

3. The vacuum deposition system according to Claim 2, wherein:
the anode is the vacuum chamber.

4. The vacuum deposition system according to Claim 2, wherein:
the evaporated material is droplets and ions comprising a material forming the cathode.

5. The vacuum deposition system according to Claim 2, further comprising:
a workpiece disposed in the interior of the vacuum chamber, wherein:
the first and second electrodes are rod members, and are aligned in a longitudinal direction of the first and second electrodes to form the gap between end surfaces of the first and second electrodes; and
the workpiece is disposed so as to face the gap.

6. The vacuum deposition system according to Claim 5, further comprising a collecting member disposed in the interior of the vacuum chamber, for collecting the evaporated material, wherein:
a surface of the collecting member is curved to surround the gap, except for a region between the workpiece and the gap

7. The vacuum deposition system according to Claim 2, having:
a first operating state in which the first electrode is the cathode; and
a second operating state in which the second electrode is the cathode.

8. The vacuum deposition system according to Claim 7, further comprising
a switching means for switching between the first operating state and the second operating state.

9. The vacuum deposition system according to Claim 8, wherein:
the electric power supply means is a DC power supply; and
the switching means is a switch for switching such that a cathode terminal of the DC power supply is connected to the first electrode or to the second electrode.

10. The vacuum deposition system according to Claim 8, wherein:
the electric power supply means is an AC power supply; and
the switching means has rectifying devices between one terminal of the AC power supply and the first electrode and between the other terminal of the AC power supply and the second electrode, for rectifying the electrical power supplied from the AC power supply.

11. The vacuum deposition system according to Claim 2, wherein the electric power supply means includes:
a first DC power supply having a negative terminal connected to the first electrode and a positive terminal connected to the anode; and
a second DC power supply having a negative terminal connected to the second electrode and a positive terminal connected to the anode.
